# FASCICULE DE BREVET EUROPEEN

(11) **EP 3 598 483 B1**
(45) Date de publication et mention de la délivrance du brevet: **23.09.2020**
(21) Numéro de dépôt: 19181725.3
(22) Date de dépôt: 21.06.2019
(51) Int. Cl.: H01L 21/683, H01L 21/60, H01L 21/98, H01L 23/00, H01L 27/15, H01L 33/62, H01L 25/075

(54) **DISPOSITIF ET PROCÉDÉS POUR LE REPORT DE PUCES D'UN SUBSTRAT SOURCE VERS UN SUBSTRAT DESTINATION**
ANORDNUNG UND VERFAHREN FÜR DIE AUFBRINGUNG VON CHIPS VON EINEM AUSGANGSSUBSTRAT AUF EIN ZIELSUBSTRAT
DEVICE AND METHODS FOR TRANSFERRING CHIPS FROM A SOURCE SUBSTRATE TO A DESTINATION SUBSTRATE

(30) Priorité: 25.06.2018 FR 1855672
(43) Date de publication de la demande: 22.01.2020
(73) Titulaire: Commissariat à l'Energie Atomique et aux Energies Alternatives, 75015 Paris (FR)
(72) Inventeur: CAPLET, Stéphane, 38054 GRENOBLE CEDEX 9 (FR); MOLLARD, Laurent, 38054 GRENOBLE CEDEX 9 (FR)
(74) Mandataire: Cabinet Beaumont

(56) Documents cités:
- FR-A1- 3 044 467
- US-A1- 2013 309 792
- US-A1- 2017 207 193
- US-A1- 2018 151 804
- US-B1- 9 368 683
- US-B1- 10 002 928

## Description

### Domaine

La présente demande concerne le domaine des techniques de transfert de puces d'un substrat source vers un substrat destination, pour la fabrication de dispositifs électroniques ou optoélectroniques, et en particulier pour la fabrication d'un dispositif d'affichage d'images comportant une pluralité de puces électroniques élémentaires montées sur un même substrat de report. La présente demande vise plus particulièrement un dispositif pour le report de puces d'un substrat source vers un substrat destination, un procédé de fabrication d'un tel dispositif, et une méthode de transfert de puces d'un substrat source vers un substrat destination au moyen d'un tel dispositif.

### Exposé de l'art antérieur

Il a déjà été proposé, dans la demande de brevet français n°1561421 déposée le 26 novembre 2015, un procédé de fabrication d'un dispositif d'affichage d'images comportant une pluralité de puces électroniques élémentaires disposées en matrice sur un même substrat de report. Selon ce procédé, les puces et le substrat de report sont fabriqués séparément. Chaque puce élémentaire comprend un empilement d'une diode électroluminescente (LED) et d'un circuit de commande de la LED. Le circuit de commande comprend une face de connexion opposée à la LED, comprenant une pluralité de plages de connexion électrique destinées à être connectées au substrat de report pour la commande de la puce. Le substrat de report comprend quant à lui une face de connexion comportant, pour chaque puce, une pluralité de plages de connexion électrique destinées à être connectées respectivement aux plages de connexion électrique de la puce. Les puces sont ensuite reportées sur le substrat de report, faces de connexion tournées vers la face de connexion du substrat de report, et fixées sur le substrat de report de façon à connecter les plages de connexion électrique de chaque puce aux plages de connexion électrique correspondantes du substrat de report.

Lors de la mise en oeuvre de l'étape de report, les puces élémentaires individualisées sont disposées sur un substrat de support, ou substrat source, chaque puce étant fixée au substrat source par sa face opposée à sa face de connexion électrique. Les puces sont ensuite positionnées en vis-à-vis des zones de connexion correspondantes du substrat de report, ou substrat destination, faces de connexion des puces tournées vers la face de connexion du substrat destination, en se servant du substrat source comme poignée. Les puces sont ensuite fixées sur le substrat destination de façon à mettre en contact les plages de connexion électrique de chaque puce avec les plages de connexion électrique correspondantes du substrat destination. Les puces sont alors détachées du substrat source, et ce dernier est retiré.

En pratique, le pas des puces élémentaires sur le substrat source peut être inférieur au pas du dispositif final, c'est-à-dire au pas des puces sur le substrat destination. Dans ce cas, on prévoit, à chaque étape de transfert, de reporter une partie seulement des puces du substrat source sur le substrat destination, au pas du substrat source, puis, si besoin, de décaler le substrat source avec les puces restantes pour reporter une autre partie des puces, et ainsi de suite jusqu'à ce que toutes les puces du dispositif d'affichage aient été fixées sur le substrat destination.

Une difficulté qui se pose dans un tel procédé est que l'énergie d'adhésion entre les puces élémentaires et le substrat source doit être précisément maitrisée. En particulier, l'énergie d'adhésion entre les puces élémentaires et le substrat source doit être suffisamment élevée pour maintenir les puces en place lors du positionnement des puces en vis-à-vis des zones de réception correspondantes du substrat destination, mais suffisamment faible pour que, une fois fixées au substrat destination, les puces se détachent du substrat source lors du retrait de ce dernier.

Le contrôle, de façon précise et reproductible, de l'énergie d'adhésion entre les puces élémentaires et le substrat source, est délicat à réaliser, ce qui pose des problèmes pratiques lors de la fabrication du dispositif d'affichage. Cette difficulté se trouve encore accentuée lorsque l'on souhaite pouvoir détacher les puces du substrat source de façon sélective pour réaliser un changement de pas entre le substrat source et le substrat destination tel que décrit ci-dessus.

Plus généralement, ce problème peut se poser dans d'autres domaines applicatifs nécessitant de transférer des puces élémentaires d'un substrat source vers un substrat destination.

La demande de brevet internationale WO2015/193435 décrit un dispositif et un procédé pour transférer des micro-objets tels que des puces électroniques d'un substrat source vers un substrat destination. Dans ce document, les micro-objets sont reliés au substrat source par des attaches mécaniques sécables prévues pour rompre lorsqu'une contrainte mécanique prédéterminée leur est appliquée. Les micro-objets sont d'abord prélevés sur le substrat source au moyen d'un substrat de transfert intermédiaire de type film élastomère (entraînant la rupture des attaches sécables), puis reportés sur le substrat destination au moyen du substrat de transfert intermédiaire. La solution proposée dans ce document présente toutefois divers inconvénients. En particulier, un inconvénient est que les attaches mécaniques sécables liant les micro-objets au substrat source occupent une surface relativement importante sur le substrat source, ce qui restreint la densité surfacique de micro-objets pouvant être prévus sur le substrat source. De plus, ce document ne décrit pas la réalisation de connexions électriques entre les micro-objets et le substrat source. Un autre inconvénient est lié à l'utilisation d'un substrat de transfert intermédiaire, qui rend la mise en oeuvre de l'opération de transfert relativement complexe (avec notamment le risque de dégrader les couches en contact avec l'outil de transfert).

Il serait souhaitable de pouvoir disposer d'une solution permettant de reporter des puces d'un substrat source sur un substrat destination, cette solution palliant au moins partiellement un ou plusieurs des inconvénients des solutions connues.

Il serait en particulier souhaitable de pouvoir disposer d'une solution de report adaptée à la fabrication d'un dispositif d'affichage du type décrit dans la demande de brevet français n°1561421 susmentionnée.

Le document US10002928 décrit un afficheur RGB à LED réalisable à base de couches minces de nitrure de gallium. Le document US2018/151804 décrit un procédé d'intégration de micro-dispositifs sur un substrat. Le document US2017/207193 décrit des dispositifs et procédés d'impression par micro transfert.

### Résumé

Ainsi, un mode de réalisation prévoit un dispositif pour le report de puces d'un substrat source vers un substrat destination, ledit dispositif étant défini par la revendication 1 et comportant :
un substrat source ayant une face inférieure et une face supérieure ; et
une pluralité de puces élémentaires disposées sur la face supérieure du substrat source,
dans lequel chaque puce élémentaire est suspendue au-dessus du substrat source par au moins une attache mécanique sécable, ladite au moins une attache mécanique sécable ayant une face inférieure fixée à la face supérieure du substrat source et une face supérieure fixée à la face inférieure de la puce.

Selon l'invention, ladite au moins une attache mécanique sécable reliant la puce au substrat source est située en totalité sous la puce.

Selon l'invention, pour chaque puce élémentaire, une partie seulement de la face inférieure de la puce est en contact avec ladite au moins une attache mécanique sécable, une autre partie de la face inférieure de la puce étant séparée de la face supérieure de l'attache mécanique sécable à par une région libre de tout matériau solide.

Selon un mode de réalisation, chaque puce élémentaire comprend une ou plusieurs bornes de connexion électrique à un dispositif extérieur disposées du côté de sa face opposée au substrat source.

Selon un mode de réalisation, chaque puce élémentaire comprend en outre une ou plusieurs bornes de connexion électrique à un dispositif extérieur disposées du côté de sa face tournée vers le substrat source.

Selon un mode de réalisation, la face supérieure du substrat source présente une rugosité de surface supérieure à 5 nm.

Selon un mode de réalisation, chaque puce élémentaire comprend une LED.

Selon un mode de réalisation, chaque puce élémentaire comprend un empilement d'une LED et d'un circuit élémentaire de commande de la LED, le circuit élémentaire de commande étant disposé du côté de la LED opposé au substrat source.

Selon un mode de réalisation, chaque puce élémentaire est un élément de conversion de longueur d'onde.

Un autre mode de réalisation prévoit un procédé de fabrication d'un dispositif tel que défini par une quelconque des revendications 1 à 7, ledit procédé étant défini par la revendication 8 et comportant les étapes successives suivantes :
a) former sur la face supérieure du substrat source un premier empilement comprenant une alternance d'au moins une couche solide permanente et d'au moins une couche sacrificielle de façon à définir les attaches mécaniques sécables du dispositif ;
b) rapporter sur la face supérieure du premier empilement une couche fonctionnelle ;
c) former des tranchées de singularisation traversant la couche fonctionnelle et délimitant les puces élémentaires du dispositif ; et
d) graver ladite au moins une couche sacrificielle de l'empilement de liaison sans retirer ladite au moins une couche solide permanente.

Un autre mode de réalisation prévoit un procédé de fabrication d'un dispositif tel que défini par une quelconque des revendications 1 à 7, ledit procédé étant défini par la revendication 9 et comportant les étapes successives suivantes :
a) former une couche fonctionnelle sur une face d'un substrat de support temporaire ;
b) former, sur la face de la couche fonctionnelle opposée au substrat de support temporaire, un empilement de liaison comprenant une alternance d'au moins une couche solide permanente et d'au moins une couche sacrificielle de façon à définir les attaches mécaniques sécables du dispositif ;
c) rapporter l'ensemble comprenant le substrat de support temporaire, la couche fonctionnelle et l'empilement de liaison sur la face supérieure du substrat source, de façon que le substrat de support temporaire soit disposé du côté de l'empilement de liaison opposé au substrat source, puis retirer le substrat de support temporaire ;
d) former des tranchées de singularisation traversant la couche fonctionnelle et délimitant les puces élémentaires du dispositif ; et
e) graver ladite au moins une couche sacrificielle de l'empilement de liaison sans retirer ladite au moins une couche solide permanente.

Selon un mode de réalisation, ladite au moins une couche solide permanente est en oxyde de silicium, et ladite au moins une couche sacrificielle est en silicium polycristallin.

Selon un mode de réalisation, l'étape de gravure de ladite au moins une couche sacrificielle de l'empilement de liaison sans retirer ladite au moins une couche solide permanente est réalisée par gravure à base de di-fluorure de xénon.

Un autre mode de réalisation prévoit un procédé de transfert de puces élémentaires d'un substrat source sur un substrat destination au moyen d'un dispositif tel que défini par une quelconque des revendications 1 à 7, ledit procédé étant défini par la revendication 12 et comprenant les étapes successives suivantes :
positionner les puces élémentaires en vis-à-vis de zones de report correspondantes du substrat destination en se servant du substrat source comme poignée ;
fixer les puces élémentaires sur le substrat destination par leur face opposée au substrat source ; et
éloigner le substrat source du substrat destination de façon à rompre les attaches mécaniques sécables reliant au substrat source les puces élémentaires désormais solidaires du substrat destination.

Selon un mode de réalisation, l'étape de fixation des puces élémentaires sur le substrat destination comprend la connexion électrique de bornes de connexion électrique préalablement formées sur la face des puces élémentaires opposée au substrat source, à des bornes de connexion électrique correspondantes du substrat destination.

Selon un mode de réalisation, le pas des puces élémentaires sur le substrat source est inférieur au pas des puces élémentaires sur le substrat destination.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F et 1G sont des vues en coupe illustrant des étapes d'un exemple d'un mode de réalisation selon l'invention d'un procédé de fabrication d'un dispositif pour le report de puces d'un substrat source sur un substrat destination ;
la figure 2 est une vue en perspective partielle du dispositif réalisé par le procédé des figures 1A à 1G ;
les figures 3A, 3B, 3C, 3D, 3E, 3F et 3G sont des vues en coupe illustrant des étapes d'un exemple d'un autre mode de réalisation d'un procédé de fabrication d'un dispositif pour le report de puces d'un substrat source sur un substrat destination; ledit exemple ne forme pas partie de l'invention mais il est utile pour comprendre l'invention ; et
les figures 4A, 4B et 4C sont des vues en coupe illustrant des étapes d'un exemple d'un mode de réalisation d'un procédé de report de puces d'un substrat source sur un substrat destination au moyen d'un dispositif réalisé par le procédé des figures 1A à 1G ou par le procédé des figures 3A à 3G. Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les structures et les fonctionnalités des puces élémentaires que l'on cherche à pouvoir transférer d'un substrat source vers un substrat destination n'ont pas été détaillées, les modes de réalisation décrits étant compatibles avec toutes ou la plupart des structures et fonctionnalités de puces connues. De plus, les structures et les fonctions des dispositifs électroniques ou optoélectroniques que l'on cherche à réaliser n'ont pas été détaillées, les modes de réalisation décrits étant compatibles avec la réalisation de tout dispositif nécessitant pour sa fabrication le report d'une ou plusieurs puces d'un substrat source vers un substrat destination.

On notera que par puce, on entend ici une microstructure en couches minces, par exemple une structure dont toutes les dimensions horizontales (c'est-à-dire les dimensions en vue de dessus) sont inférieures à 5 mm, par exemple inférieures à 1 mm, par exemple inférieures à 0,5 mm, par exemple inférieures à 0,1 mm, par exemple inférieures à 50 µm, et dont l'épaisseur est inférieure à 1 mm, par exemple inférieure à 0,5 mm, par exemple inférieure à 0,1 mm, par exemple inférieure à 50 µm. Au sens de la présente description, une puce peut comprendre un ou plusieurs composants électroniques actifs et/ou passifs, et/ou un ou plusieurs composants optoélectroniques, et/ou un ou plusieurs composants optiques.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, en pratique, les structures décrites peuvent être orientées différemment. Sauf précision contraire, les expressions "approximativement", "sensiblement", et "de l'ordre de" signifient à 10 % près, de préférence à 5 % près.

On prévoit ici de réaliser un assemblage comportant un substrat source ayant une face inférieure et une face supérieure, et une pluralité de puces élémentaires disposées sur la face supérieure du substrat source, chaque puce étant maintenue suspendue au-dessus du substrat source par au moins une attache ou liaison mécanique sécable. Selon un aspect de l'invention, chaque attache mécanique sécable a une face inférieure fixée à la face supérieure du substrat source et une face supérieure fixée à la face inférieure de la puce correspondante. Ainsi, chaque attache mécanique sécable est située entièrement sous (à l'aplomb de) la puce correspondante. Ceci constitue une différence par rapport aux solutions décrites dans la demande de brevet internationale WO2015/193435 susmentionnée, dans lesquelles les attaches mécaniques sécables sont situées à côté des puces et fixées aux faces latérales des puces, ce qui limite la densité surfacique de puces (nombre de puces par unité de surface) pouvant être prévue sur la face supérieure du substrat source. Selon l'invention, chaque attache mécanique sécable est située en totalité sous la puce correspondante, de façon à maximiser la densité surfacique de puces pouvant être prévue sur la face supérieure du substrat source.

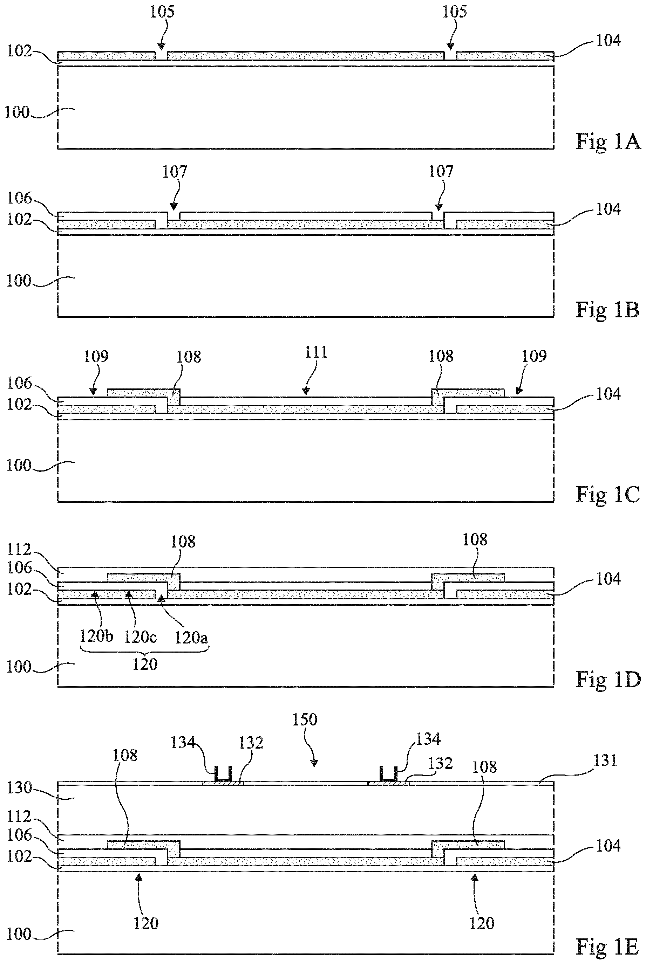

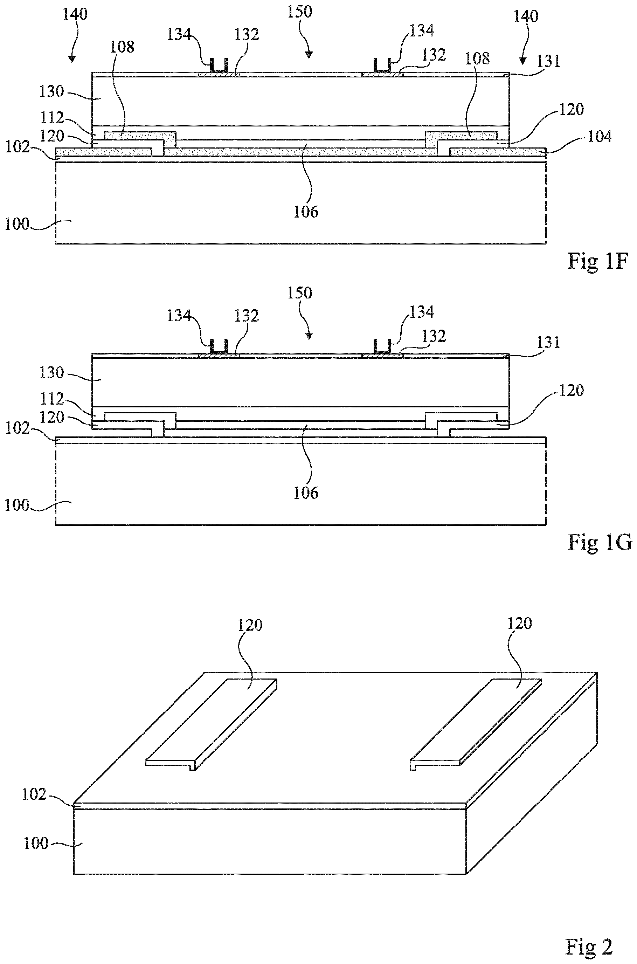

Les figures 1A, 1B, 1C, 1D, 1E, 1F et 1G sont des vues en coupe schématiques et partielles illustrant des étapes successives d'un exemple d'un mode de réalisation d'un procédé de fabrication d'un dispositif pour le report de puces d'un substrat source sur un substrat destination. Plus particulièrement, les figures 1A à 1G illustrent des étapes d'un procédé de fabrication d'un dispositif comportant un substrat source 100, et une pluralité de puces élémentaires 150, par exemple identiques ou similaires, suspendues au-dessus de la face supérieure du substrat 100, chaque puce 150 étant reliée au substrat 100 par au moins une attache sécable (deux dans l'exemple des figures 1A à 1G) reliant la face supérieure du substrat source 100 à la face inférieure de la puce 150. Par souci de simplification, une seule puce 150, ainsi que la portion correspondante du substrat 100, sont représentés sur les figures 1A à 1G, étant entendu que, en pratique, un grand nombre de puces 150 peuvent être formées simultanément sur la face supérieure du substrat 100.

La figure 1A illustre une étape de dépôt, sur la face supérieure du substrat source 100, par exemple un substrat en silicium, d'une couche de protection 102, par exemple en oxyde de silicium. La couche 102 est par exemple en contact avec la face supérieure du substrat 100. A titre d'exemple, la couche 102 s'étend de façon continue sur toute la surface supérieure du substrat 100. A titre d'exemple, la couche 102 présente une épaisseur comprise entre 0,1 et 1 µm.

La figure 1A illustre en outre une étape de dépôt d'une couche sacrificielle 104 sur la face supérieure de la couche de protection 102, par exemple en contact avec la face supérieure de la couche de protection 102. La couche 104 est en un matériau gravable de façon sélective par rapport au matériau de la couche 102. A titre d'exemple, la couche 104 est en silicium polycristallin. La couche 104 a par exemple une épaisseur comprise entre 100 et 500 nm. La couche 104 comprend des ouvertures traversantes 105 débouchant sur la face supérieure de la couche de protection 102, définissant des zones d'ancrage des attaches mécaniques sécables à la face supérieure de la couche de protection 102. Dans cet exemple, pour chaque puce élémentaire 150, deux ouvertures 105 disjointes sont formées dans la couche sacrificielle 104, correspondant respectivement aux zones d'ancrage des deux attaches mécaniques sécables reliant la puce 150 au substrat 100. A titre d'exemple, la couche sacrificielle est d'abord déposée de façon continue sur toute la surface supérieure de la couche de protection 102, puis retirée localement par photolithographie et gravure pour former les ouvertures 105. Les ouvertures 105 sont par exemple disposées sous les (à l'aplomb des) futures puces 150 du dispositif. A titre d'exemple, pour chaque puce 150 du dispositif, les ouvertures 105 ont la forme de deux bandes parallèles, par exemple rectilignes, disposées sous deux moitiés distinctes de la puce 150. A titre d'exemple, chaque ouverture 105 a une longueur (non visible sur la figure 1A) sensiblement égale à la dimension horizontale de la puce 150 dans la direction longitudinale de la bande. Chaque ouverture 105 a par exemple une largeur comprise entre 0,1 et 10 µm, par exemple entre 0,2 et 2 µm.

La figure 1B illustre une étape de dépôt, sur et en contact avec la face supérieure de la couche sacrificielle 104, d'une couche 106 d'un matériau tel que le matériau de la couche 104 soit gravable de façon sélective par rapport aux matériaux des couches 102 et 106. A titre d'exemple, la couche 106 est en le même matériau que la couche 102. La couche 106 est déposée sur une épaisseur supérieure à celle de la couche sacrificielle 104, de manière à combler entièrement les ouvertures 105 préalablement formées dans la couche sacrificielle 104. La couche 106 peut ensuite être planarisée, par exemple par polissage mécano-chimique (CMP), de façon qu'une épaisseur non nulle de la couche 106 subsiste au-dessus de la face supérieure de la couche sacrificielle 104 à l'issue de l'étape de planarisation. A titre d'exemple, à l'issue de l'étape de planarisation, l'épaisseur de la couche 106 au-dessus de la face supérieure de la couche sacrificielle 104 est comprise entre 50 et 500 nm, par exemple entre 100 et 200 nm.

Dans cet exemple, les attaches mécaniques sécables reliant les puces 150 au substrat 100 sont formées dans la couche 106. La couche 106 comprend, pour chaque puce 150, une ou plusieurs ouvertures traversantes 107 débouchant sur la face supérieure de la couche sacrificielle 104 et délimitant au moins partiellement la ou les attaches mécaniques sécables destinées à relier la puce 150 au substrat 100. Dans l'exemple représenté, pour chaque puce 150, la couche 106 comprend deux ouvertures traversantes 107 disjointes ayant, en vue de dessus, la forme de bandes rectilignes parallèles aux ouvertures 105 préalablement formées dans la couche 104 (figure 1A). Plus particulièrement, dans cet exemple, vu de dessus, les deux ouvertures 107 sont disposées entre les deux ouvertures 105, par exemple respectivement juxtaposées aux deux ouvertures 105. A titre d'exemple, chaque ouverture 107 a une longueur supérieure ou égale à la dimension horizontale de la puce 150 dans la direction longitudinale de la bande. Chaque ouverture 107 a par exemple une largeur comprise entre 0,05 et 10 µm, par exemple entre 0,1 et 1 µm. A titre d'exemple, la couche 106 est d'abord déposée de façon continue sur toute la surface de la structure obtenue à l'issue des étapes de la figure 1A, puis retirée localement par photolithographie et gravure pour former les ouvertures 107.

La figure 1C illustre une étape de dépôt d'une deuxième couche sacrificielle 108 sur et en contact avec la face supérieure de la couche 106. La couche 108 est en un matériau tel que la couche 108 soit gravable sélectivement par rapport aux couches 102 et 106. A titre d'exemple, la couche 108 est en le même matériau que la couche 104. L'épaisseur de la couche 108 est supérieure à l'épaisseur de la couche 106 au-dessus de la couche sacrificielle 104, de façon que la couche 108 comble entièrement les ouvertures 107 préalablement formées dans la couche 106 (figure 1B). A titre d'exemple, l'épaisseur de la couche 108 est comprise entre 100 et 500 nm.

La couche 108 est par exemple déposée sur toute la surface supérieure de la structure obtenue à l'issue des étapes des figures 1A et 1B, puis retirée localement, par exemple par photolithographie et gravure, pour définir des zones 109 d'ancrage des attaches mécaniques sécables à la puce 150. Plus particulièrement, dans cet exemple, chaque zone d'ancrage 109 est disposée, en vue de dessus, à distance d'une ouverture 105 (figure 1A) préalablement formée dans la couche sacrificielle inférieure 104 (c'est-à-dire non juxtaposée à une ouverture 105), du côté de l'ouverture 105 opposé à l'ouverture 107 (figure 1B) préalablement formée dans la couche 106. Dans l'exemple représenté, la couche 108 est en outre retirée en regard d'une partie centrale 111 de la puce située, en vue de dessus, entre les deux ouvertures 107 préalablement formées dans la couche 106.

La figure 1D illustre une étape de dépôt d'une couche de protection supérieure 112 sur et en contact avec la face supérieure de la structure obtenue à l'issue des étapes des figures 1A, 1B et 1C. La couche 112 s'étend sur toute la surface supérieure de la structure, c'est-à-dire sur et en contact avec la face supérieure de la couche 108 et sur et en contact avec la face supérieure de la couche 106 dans les régions 109 et 111 dans lesquelles la couche 108 a été retirée. La couche 112 est en un matériau tel que les couches 104 et 108 soient gravables sélectivement par rapport à la couche 112. A titre d'exemple, la couche 112 est en le même matériau que la couche 102 ou que la couche 106. La couche 112 est déposée sur une épaisseur supérieure à celle de la couche sacrificielle 108, de manière à combler entièrement les ouvertures 109 et 111 préalablement formées dans la couche 108. La couche 112 peut ensuite être planarisée, par exemple par polissage mécano-chimique (CMP). A titre d'exemple, à l'issue de l'étape de planarisation, une épaisseur non nulle de la couche 112 subsiste au-dessus de la face supérieure de la couche sacrificielle 108, par exemple une épaisseur comprise entre 50 nm et 5 µm, par exemple entre 100 nm et 1 µm.

A ce stade, des attaches mécaniques sécables 120 du dispositif sont définies. Plus particulièrement chaque attache mécanique sécable 120 comprend :
- au niveau d'une ouverture 105 formée dans la couche sacrificielle 104 (figure 1A), une première portion 120a de la couche 106 dont la face inférieure est en contact avec la face supérieure de la couche de protection inférieure 102, et dont la face supérieure est séparée de la couche de protection supérieure 112 par la couche sacrificielle 108 ;
- au niveau d'une ouverture 109 formée dans la couche sacrificielle 108 (figure 1C), une deuxième portion 120b de la couche 106 dont la face supérieure est en contact avec la face inférieure de la couche de protection supérieure 112 et dont la face inférieure est séparée de la couche de protection inférieure 102 par la couche sacrificielle 102 ; et
- entre l'ouverture 105 et l'ouverture 109, une troisième portion 120c de la couche 106 s'étendant horizontalement depuis un bord latéral de la première portion 120a jusqu'à un bord latéral de la deuxième portion 120b.

La zone de rupture de chaque attache mécanique sécable 120 correspond par exemple à sa portion horizontale 120c, ou à la jonction entre sa portion horizontale 120c et sa portion verticale 120a. L'énergie à appliquer pour rompre les attaches 120 peut être contrôlée de façon précise en adaptant le dimensionnement des attaches, et en particulier l'épaisseur de la couche 106 et les dimensions de la portion horizontale 120c de l'attache.

Un traitement thermique de normalisation peut éventuellement être prévu après la réalisation de la couche de protection supérieure 112, par exemple un recuit à une température de l'ordre de 1000°C d'une durée comprise entre 0,5 et 2 heures, par exemple de l'ordre de 1 heure, ou un recuit à une température de l'ordre de 1200°C d'une durée comprise entre 1 et 10 secondes, par exemple de l'ordre de 3 secondes.

La figure 1E illustre une étape de réalisation des puces élémentaires 150 sur la face supérieure de la couche de protection 112. La figure 1E illustre plus particulièrement une étape de report d'une couche fonctionnelle 130 sur la face supérieure de la couche de protection 112, et de réalisation des puces élémentaires 150 dans et/ou sur la couche fonctionnelle 130. La réalisation des puces élémentaires 150 n'est pas détaillée, les solutions proposées étant compatibles avec la plupart des structures usuelles de puces élémentaires.

A titre d'exemple, la couche 130 est une couche de silicium, les puces élémentaires 150 étant des puces de circuit intégré réalisées dans et sur la couche de silicium 130, par exemple en technologie CMOS.

Dans un autre exemple de réalisation, la couche 130 est une couche d'un matériau semiconducteur III-V, par exemple du nitrure de gallium, les puces élémentaires 150 étant des diodes électroluminescentes réalisées dans et sur la couche 130.

Dans un autre exemple de réalisation, la couche 130 est une couche de silicium, les puces élémentaires 150 étant des cellules photovoltaïques réalisées dans et sur la couche de silicium 130.

Dans les exemples susmentionnés, chaque puce élémentaire 150 peut comporter, sur sa face supérieure, c'est-à-dire sur sa face opposée au substrat source 100, une ou plusieurs bornes 132 de connexion électrique de la puce à un dispositif extérieur (deux bornes 132 dans l'exemple représenté), par exemple sous la forme de plages métalliques affleurant la face supérieure des puces 150. Dans l'exemple représenté, la couche 130 est revêtue, du côté de sa face supérieure, d'une couche isolante 131, par exemple en oxyde de silicium, les plages métalliques 132 étant disposées dans des ouvertures formées dans la couche isolante 131.

La figure 1E illustre en outre une étape optionnelle de formation de microstructures conductrices 134 sur la face supérieure des bornes de connexion électrique 132, en vue de faciliter la mise en oeuvre d'une étape ultérieure de fixation et de connexion électrique des puces à un dispositif extérieur. A titre d'exemple, les microstructures 134 sont des microtubes métalliques, par exemple en tungstène, formés par un procédé du type décrit dans la demande de brevet US2011/094789. A titre de variante, les microstructures 132 sont des micropointes du type décrit dans la demande de brevet US2008/190655.

Dans les exemples susmentionnés, chaque puce élémentaire peut en outre comporter, sur sa face inférieure, c'est-à-dire sur sa face tournée vers le substrat source 100, une ou plusieurs bornes (non visibles sur les figures) de connexion électrique de la puce 150 à un dispositif extérieur, par exemple sous la forme de plages métalliques affleurant la face inférieure de la puce.

A titre de variante de réalisation, la couche 130 est une couche de conversion de longueur d'onde, par exemple une couche de phosphore, ou une couche d'une matrice comprenant des boîtes quantiques, ou un empilement de puits quantiques multiples, les puces élémentaires 150 étant alors des éléments de conversion de couleur. Dans ce cas, les puces élémentaires 150 peuvent ne pas comprendre de borne de connexion électrique. Plus généralement, dans le cas où les puces élémentaires 150 comprennent uniquement des composants optiques passifs, ces dernières peuvent ne pas comporter de borne de connexion électrique.

Lors de l'étape de report de la couche fonctionnelle 130 sur la face supérieure de la couche de protection supérieure 112, la face inférieure de la couche 130 peut être fixée à la face supérieure de la couche 112, éventuellement par l'intermédiaire d'une ou plusieurs couches intermédiaires, par exemple par collage moléculaire, par thermocompression, ou par toute autre méthode de fixation adaptées.

La figure 1F illustre une étape de gravure, depuis la face supérieure de l'assemblage obtenu à l'issue des étapes des figures 1A à 1E, de tranchées 140 de singularisation des puces élémentaires 150. Plus particulièrement, dans l'exemple représenté, les tranchées 140 s'étendent verticalement depuis la face supérieure de l'assemblage, traversent entièrement la couche fonctionnelle 130 et la couche supérieure de protection 112, et débouchent sur la face supérieure de la couche sacrificielle 104. Les tranchées 140 entourent entièrement chaque puce élémentaire 150 de l'assemblage, de façon à séparer les puces élémentaires les unes des autres. Les tranchées 140 sont par exemple réalisées par gravure réactive ionique (RIE).

La figure 1G illustre une étape de retrait des couches sacrificielles 104 et 108, par gravure sélective des couches 104 et 108 par rapport aux autres éléments de l'assemblage. Le retrait des couches 104 et 108 est par exemple réalisé par gravure à base de di-fluorure de xénon (XeF2). D'autres procédés de gravure peuvent toutefois être utilisés, par exemple une gravure chimique humide, auquel cas une étape de séchage peut être prévue à l'issue de l'étape de gravure, par exemple un séchage supercritique au CO₂. Lors de cette étape, la gravure de la couche 108 est réalisée via les zones de raccordement entre la couche 104 et la couche 108 définies par les ouvertures 107 de la figure 1B. La gravure des couches sacrificielles 104 et 108 conduit à libérer les puces 150 et les attaches mécaniques sécables 120. On notera que selon le procédé de gravure utilisé, une passivation des flancs des puces peut être réalisée préalablement à la gravure, pour éviter que le substrat de la puce ne soit attaqué pendant la gravure des couches sacrificielles.

A l'issue de cette étape, on obtient un assemblage comportant une pluralité de puces élémentaires 150 suspendues au-dessus de la face supérieure du substrat source 100 par des attaches mécaniques sécables 120. Dans cet exemple, la couche de protection supérieure 112 et la portion centrale de la couche 106 (la portion de la couche 106 située, en vue de dessus, entre les ouvertures 107 formées dans la couche 106 à l'étape décrite en relation avec la figure 1B) sont considérées comme faisant partie de la puce élémentaire 150. A ce stade, seules les attaches mécaniques sécables 120 relient la puce 150 au substrat source 100. Chaque attache 120 a une face inférieure fixée à la face supérieure du substrat source 100 (par l'intermédiaire de la couche de protection inférieure 102 solidaire du substrat 100 dans cet exemple) et une face supérieure fixée à la face inférieure de la puce 150. Pour chaque puce élémentaire 150, la surface des attaches 120 en contact avec la face inférieure de la puce est inférieure à la surface totale de la face inférieure de la puce, par exemple inférieure à la moitié de la surface totale de la face inférieure de la puce, par exemple inférieure à 20 % de la surface totale de la face inférieure de la puce, par exemple inférieure à 5 % de la surface totale de la face inférieure de la puce. Le reste de la surface de la face inférieure de la puce est séparée de la face supérieure du substrat source 100 par une région libre de tout matériau solide. Dans l'exemple décrit ci-dessus, chaque attache mécanique sécable 120 est entièrement située sous (à l'aplomb de) la puce 150 à laquelle elle est associée, ce qui permet de maximiser la densité surfacique de puces pouvant être prévue sur la face supérieure du substrat source.

La figure 2 est une vue en perspective illustrant les attaches mécaniques sécables 120 réalisées par le procédé décrit ci-dessus. Par souci de clarté, la puce 150 n'a pas été représentée sur la figure 2. Comme cela apparaît sur la figure 2, chaque attache 120 a, vu de dessus, la forme d'une bande rectiligne, et, en section transversale, une forme en L couché, la barre verticale du L couché ayant son extrémité libre fixée à la face supérieure du substrat source 100 et la barre horizontale du L couché ayant son extrémité libre fixée à la face inférieure de la puce 150.

On notera que les modes de réalisation décrits ne se limitent pas à l'exemple décrit ci-dessus dans lequel chaque puce est reliée au substrat par deux attaches mécaniques sécables en forme de bande rectiligne (en vue de dessus). Plus généralement, le nombre d'attaches peut être différent de deux (au moins une attache). A titre de variante, chaque puce peut être reliée au substrat par quatre attaches mécaniques sécables disposées respectivement en vis-à-vis de quatre coins de la puce. De plus, la largeur de la partie horizontale des attaches (largeur des bandes dans l'exemple de la figure 2) peut être variable. A titre d'exemple, en vue de dessus, les attaches mécaniques sécables peuvent avoir une forme triangulaire, une forme en V (qui peut être favorable à une concentration des contraintes au moment de l'arrachement ce qui permet de rompre plus facilement l'attache), ou toute autre forme adaptée.

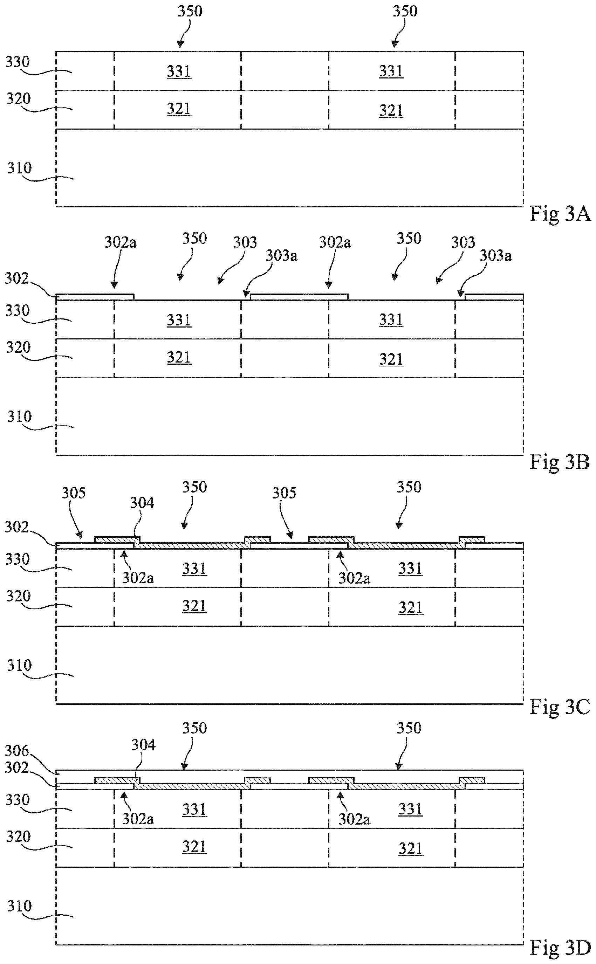

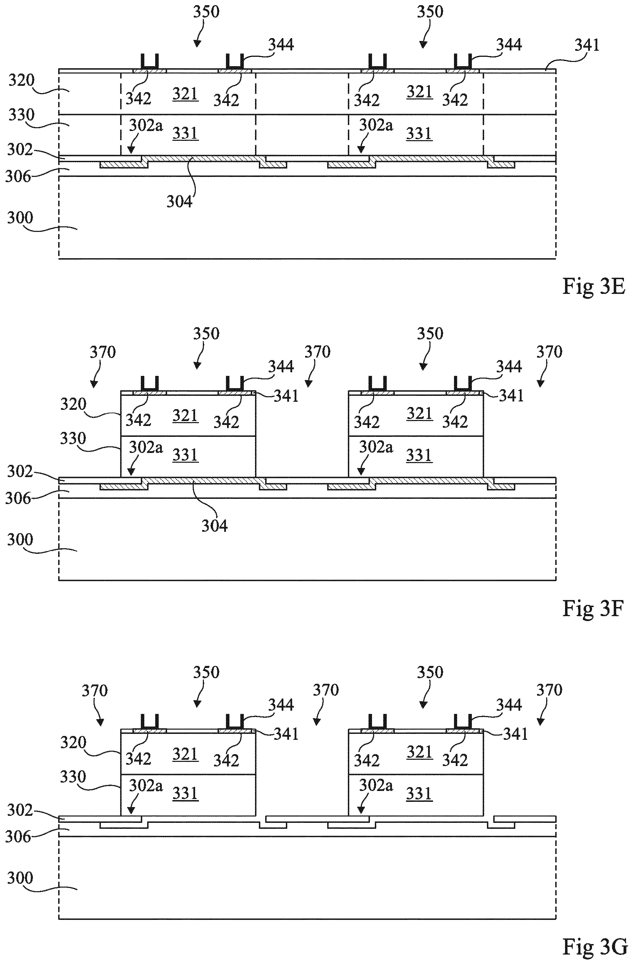

Les figures 3A, 3B, 3C, 3D, 3E, 3F et 3G sont des vues en coupe illustrant des étapes d'un exemple d'un autre mode de réalisation d'un procédé de fabrication d'un dispositif pour le report de puces d'un substrat source sur un substrat destination. Plus particulièrement, les figures 3A à 3G illustrent des étapes d'un procédé de fabrication d'un dispositif comportant un substrat source 300, et une pluralité de puces élémentaires 350, par exemple identiques ou similaires, suspendues au-dessus de la face supérieure du substrat 300, chaque puce 350 étant reliée au substrat 300 par au moins une attache mécanique sécable (une seule attache dans l'exemple des figures 3A à 3G) reliant la face supérieure du substrat source 300 à la face inférieure de la puce 350. Par souci de simplification, seules deux puces 350, ainsi que la portion correspondante du substrat 300, sont représentés sur les figures 3A à 3G, étant entendu que, en pratique, un grand nombre de puces 350 peuvent être formées simultanément sur la face supérieure du substrat 300.

Dans cet exemple, chaque puce élémentaire 350 comprend un empilement d'une LED à base d'un matériau semiconducteur III-V tel que le nitrure de gallium, et d'un circuit de commande de la LED, par exemple un circuit CMOS. A titre d'exemple, les puces élémentaires 350 sont des puces du type décrit dans la demande de brevet français n°1561421 susmentionnée. Les modes de réalisation décrits ne se limitent toutefois pas à ce cas particulier. Plus généralement, le procédé des figures 3A à 3G peut être adapté à tout autre type de puces semiconductrices, par exemple des puces comportant uniquement une LED (sans circuit de contrôle CMOS), des puces comportant uniquement un circuit CMOS, des puces photovoltaïques, etc.

La figure 3A illustre une étape de réalisation d'un assemblage comportant un empilement d'un substrat de support temporaire 310, d'un substrat semiconducteur 320, par exemple en silicium, dans et sur lequel sont formés une pluralité de circuits de commande élémentaires 321 correspondant respectivement aux circuits de commande des différentes puces élémentaires 350, et d'un substrat semiconducteur 330, par exemple en un matériau semiconducteur III-V, par exemple en nitrure de gallium, dans et sur lequel sont formées une pluralité de LED 331 correspondant respectivement aux LED des différentes puces élémentaires 350. Dans cet exemple, la face inférieure du substrat semiconducteur 320 repose sur la face supérieure du substrat de support 310, et la face inférieure du substrat semiconducteur 330 repose sur la face supérieure du substrat semiconducteur 320.

A titre d'exemple, le substrat 320 est d'abord reporté seul sur la face supérieure du substrat de support 310, puis traité pour réaliser les circuits de commande élémentaire 321, par exemple en technologie CMOS. Chaque circuit de commande élémentaire 321 comprend par exemple un ou plusieurs transistors adaptés à commander le courant et/ou la tension appliqués à la LED 331 de la puce. Chaque circuit de commande élémentaire 321 comprend, du côté de sa face opposée au substrat de support 330, c'est-à-dire du côté de sa face supérieure dans l'exemple représenté, au moins une borne de connexion électrique du circuit 321 à la LED 331.

Le substrat 330 peut quant à lui être formé séparément sur un substrat de croissance (non représenté), puis traité pour réaliser les LED élémentaires 331. Le substrat 330 est ensuite reporté sur la face supérieure du substrat 320 de façon à connecter chaque LED élémentaire 331 du substrat 330 au circuit de commande élémentaire 321 correspondant du substrat 320. Le substrat de croissance est alors retiré de façon à obtenir l'empilement représenté sur la figure 3A. A titre de variante, l'empilement de couches semiconductrices constitutives des LED peut être rapporté sur le substrat 320 avant individualisation des LED élémentaires 331. Le substrat de croissance de l'empilement de couches semiconductrices constitutives des LED est alors retiré pour permettre l'individualisation des LED.

A l'issue des étapes de la figure 3A, les puces élémentaires 350 de l'assemblage ne sont pas encore individualisées. Les traits interrompus verticaux des figures 3A à 3E délimitent les bords latéraux des futures puces élémentaires individualisées.

Les figures 3B à 3D illustrent des étapes de fabrication des attaches mécaniques sécables destinées à relier les puces élémentaires 350 au substrat source 300.

La figure 3B illustre plus particulièrement une étape de dépôt, sur la face supérieure du substrat 330, d'une couche d'ancrage inférieure 302, par exemple en oxyde de silicium. La couche 302 est par exemple en contact avec la face supérieure du substrat 330. La couche 302 comprend des ouvertures traversantes 303 débouchant sur la face supérieure du substrat 330. Dans cet exemple, pour chaque puce élémentaire 350, la couche 302 comprend une ouverture 303 s'étendant sur toute la surface de la puce, sauf au niveau d'une partie d'une région périphérique de la puce dans laquelle la couche 302 déborde sur la face supérieure de la puce. Plus particulièrement, dans cet exemple, pour chaque puce élémentaire 350, l'ouverture 303 s'étend sur toute la surface de la puce sauf au niveau d'un bord latéral de la puce, où une portion 302a de la couche 302 forme une languette à cheval sur le bord de la puce, c'est-à-dire ayant une partie de sa surface inférieure en contact avec la face supérieure de la puce et une autre partie de sa surface inférieure en contact avec la face supérieure du substrat 330 dans une région du substrat 330 externe et adjacente à la puce. Au niveau d'au moins une autre partie de la périphérie de chaque puce, par exemple du côté du bord latéral de la puce opposé à la région 302a, l'ouverture 303 s'étend au-delà du bord latéral de la puce. Autrement dit, chaque ouverture 303 comprend une portion 303a s'étendant, en vue de dessus, au-dessus d'une région du substrat 330 externe et adjacente à la puce. A titre d'exemple, la couche 302 est d'abord déposée de façon continue sur toute la surface supérieure du substrat 330, puis retirée localement par photolithographie et gravure pour former les ouvertures 303.

La figure 3C illustre une étape de dépôt d'une couche sacrificielle 304 sur la face supérieure de l'assemblage obtenu à l'issue des étapes des figures 3A et 3B. La couche 304 est en un matériau gravable de façon sélective par rapport au matériau de la couche 302. A titre d'exemple, la couche 304 est en silicium polycristallin. Plus généralement, tout autre matériau sacrificiel adapté peut être utilisé, par exemple de l'aluminium. La couche 304 s'étend notamment sur et en contact avec la face supérieure des puces 350 au fond des ouvertures 303, et s'étend en outre sur et en contact avec la couche 302, en dehors des ouvertures 303, et en particulier sur les portions 302a de la couche 302. La couche 304 comprend, pour chaque puce 350, une ouverture traversante 305 débouchant sur la face supérieure de la languette 302a de la couche 302 associée à la puce. En vue de dessus, l'ouverture 305 est située à l'extérieur de la puce 350 et à distance du bord latéral de la puce. A titre d'exemple, la couche 304 est d'abord déposée de façon continue sur toute la surface supérieure de l'assemblage obtenu à l'issue des étapes des figures 3A et 3B, puis retirée localement par photolithographie et gravure pour former les ouvertures 305.

La figure 3D illustre une étape de dépôt, sur la face supérieure de l'assemblage obtenu à l'issue des étapes des figures 3A, 3B et 3C, d'une couche d'ancrage supérieure 306 en un matériau tel que la couche sacrificielle 304 soit gravable de façon sélective par rapport aux couches 302 et 306. A titre d'exemple, la couche 306 est en le même matériau que la couche 302. Dans cet exemple, la couche 306 s'étend de façon continue sur toute la surface supérieure de l'assemblage, c'est-à-dire sur et en contact avec la couche sacrificielle 304 en dehors des ouvertures 305 formées dans la couche sacrificielle à l'étape précédente, et sur et en contact avec la couche d'ancrage inférieure 302 dans les ouvertures 305. La couche 306 est par exemple déposée sur une épaisseur supérieure à celle de la couche sacrificielle 305 de façon à combler entièrement les ouvertures 305 préalablement formées dans la couche sacrificielle 304, puis planarisée, par exemple par polissage mécano-chimique (CMP). A titre d'exemple, à l'issue de l'étape de planarisation, une épaisseur non nulle de la couche 306 subsiste au-dessus de la face supérieure de la couche sacrificielle 304, par exemple une épaisseur comprise entre 50 et 500 nm, par exemple entre 100 et 200 nm.

La figure 3E illustre une étape de report de la structure obtenue à l'issue des étapes des figures 3A à 3D sur un substrat de support 300, correspondant au substrat source du dispositif final, puis de retrait du substrat de support temporaire 310. Lors de cette étape, la face de la couche 306 opposée aux substrats 330, 320 et 310 (c'est-à-dire la face inférieure de la couche 306 dans l'orientation de la figure 3E) est collée, par exemple par collage moléculaire, à une face (la face supérieure dans l'orientation de la figure 3E) du substrat source 300. Le substrat temporaire 310 est ensuite retiré, par exemple par meulage et gravure chimique, de façon à libérer l'accès à la face du substrat 320 opposée au substrat 330 (c'est-à-dire la face supérieure du substrat 320 dans l'orientation de la figure 3E).

La figure 3E illustre en outre une étape postérieure au retrait du substrat 310, de réalisation, sur la face supérieure des puces 350, de bornes 342 de connexion électrique de la puce 150 à un dispositif extérieur (deux bornes 342 par puce dans l'exemple représenté). A titre d'exemple, les bornes 342 sont des plages métalliques affleurant la face supérieure des puces 350. Dans l'exemple représenté, la face supérieure du substrat 320 est revêtue d'une couche isolante 341, par exemple en oxyde de silicium, les plages métalliques 342 étant disposées dans des ouvertures formées dans la couche isolante 341.

La figure 3E illustre en outre une étape optionnelle de formation de microstructures conductrices 344 sur la face supérieure des bornes de connexion électrique 342, en vue de faciliter la fixation ultérieure des micropuces à un dispositif extérieur, par exemple des microtubes ou des micropointes du type décrit en relation avec la figure 1E.

La figure 3F illustre une étape de gravure, depuis la face supérieure de l'assemblage obtenu à l'issue des étapes des figures 3A à 3E, de tranchées 370 de singularisation des puces élémentaires 350. Plus particulièrement, dans l'exemple représenté, les tranchées 370 s'étendent verticalement depuis la face supérieure de l'assemblage, traversent entièrement la couche 341 et les substrats 320 et 330, et débouchent sur la face supérieure de la couche 302 (au niveau des régions d'ancrage 302a) et de la couche sacrificielle 304 (au niveau des régions de débordement 303a de l'ouverture 303 de la figure 3B). Les tranchées 370 sont par exemple réalisées par gravure réactive ionique (RIE).

La figure 3G illustre une étape de retrait de la couche sacrificielle 304, par gravure sélective de la couche 304 par rapport aux autres éléments de l'assemblage. Le retrait de la couche 304 est par exemple réalisé par gravure à base de di-fluorure de xénon (XeF2) dans le cas d'une couche sacrificielle en silicium polycristallin.

A l'issue de cette étape, on obtient un assemblage comportant une pluralité de puces élémentaires 350 disposées sur la face supérieure du substrat source 300, chaque puce 350 comportant un empilement d'une LED 331 disposée côté substrat source 300, et d'un circuit de commande 321 disposé du côté de la face de la LED 331 opposée au substrat source 300. Dans chaque puce, la LED 331 est connectée électriquement au circuit de commande 321, et le circuit de commande 321 comprend, sur sa face opposée à la LED, des bornes de connexion de la puce à un dispositif extérieur. Chaque puce 350 est maintenue suspendue au-dessus du substrat source 300 par une attache mécanique sécable formée par la région 302a de la couche 302 fixée à la face inférieure de la puce. Plus particulièrement, chaque attache 302a forme une languette comprenant :
- une première région située sous la puce 350, dont la face supérieure est fixée à la face inférieure de la puce et dont la face inférieure est séparée de la face supérieure de la couche 306 par une région libre de tout matériau solide ;
- une deuxième région opposée à la première région, située, en vue de dessus, à distance de la puce et de la première région, dont la face inférieure est fixée à la face supérieure de la couche 306 ; et
- une troisième région intermédiaire reliant la première région à la deuxième région, la troisième région ayant sa face inférieure séparée de la face supérieure de la couche 306 par une couche libre de tout matériau solide.

La zone de rupture de chaque attache mécanique sécable 302a correspond à sa troisième région, c'est-à-dire à la portion horizontale de la couche 302 située entre la région de fixation de la languette à la face supérieure de la couche 306 et la région de fixation de la languette à la face inférieure de la puce. L'énergie à appliquer pour rompre les attaches 302a peut être contrôlée en adaptant le dimensionnement des attaches (et des zones 304).

Là encore, les modes de réalisation décrits ne se limitent pas à l'exemple décrit ci-dessus dans lequel chaque puce est reliée au substrat par deux attaches mécaniques sécables en forme de bande rectiligne (en vue de dessus). Plus généralement, le nombre d'attaches mécaniques sécables peut être différent de deux (au moins une attache) et la forme des attaches peut être différente de ce qui a été décrit précédemment.

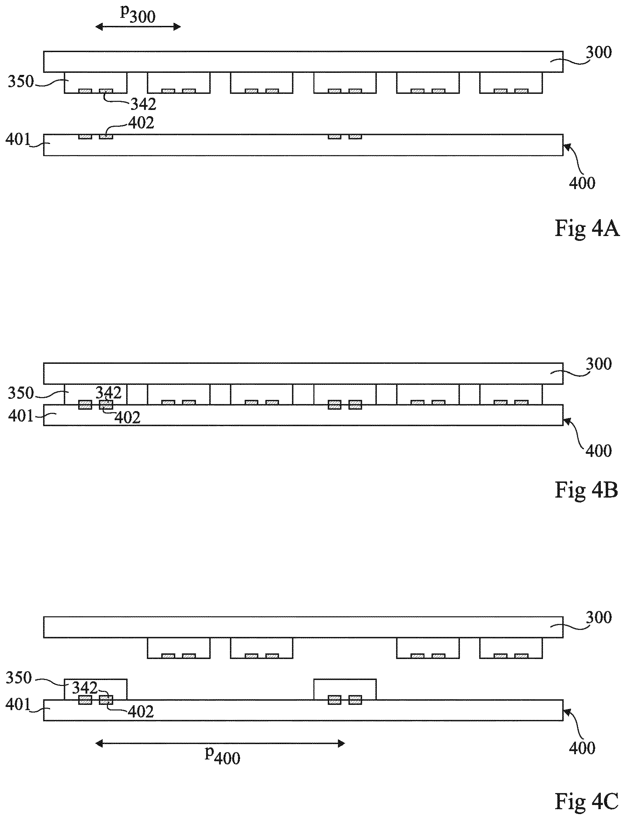

Les figures 4A, 4B et 4C sont des vues en coupe illustrant des étapes d'un exemple d'un mode de réalisation d'un procédé de report de puces d'un substrat source sur un substrat destination au moyen d'un dispositif réalisé par le procédé des figures 3A à 3G, étant entendu qu'un procédé de report similaire peut être mis en oeuvre à partir d'un dispositif réalisé par le procédé des figures 1A à 1G.

A titre d'exemple, le procédé des figures 4A à 4C peut être mis en oeuvre lors de la fabrication d'un dispositif d'affichage émissif à LED. Dans cet exemple, le substrat source correspond au substrat 300 du dispositif de la figure 3G, et le substrat destination 400 comprend une plaque ou une feuille de support 401 en un matériau isolant, sur laquelle sont disposés des éléments de connexion électrique, par exemple des pistes et plages conductrices. Le substrat destination 400 est par exemple un substrat passif, c'est-à-dire qu'il comprend uniquement des éléments de connexion électrique pour l'amenée des signaux de commande et d'alimentation des puces élémentaires 350 (correspondant à des pixels du dispositif d'affichage). A titre de variante, les puces élémentaires du dispositif sont des LED simples, sans circuit de commande intégré, auquel cas le substrat destination 400 peut être un substrat actif, par exemple un circuit CMOS, intégrant des circuits de commande des LED. Le substrat destination 400 comprend une face de connexion, sa face supérieure dans l'exemple représenté, destinée à recevoir les puces 350. Pour chaque puce du dispositif final, le substrat destination 400 comprend, sur sa face de connexion, une pluralité de plages de connexion électrique 402 (une par borne de connexion électrique de la puce) destinées à être connectées respectivement aux bornes de connexion électrique de la puce.

La figure 4A illustre une étape au cours de laquelle, après avoir formé séparément les puces 350 sur le substrat source 300, et le substrat destination 400, on vient positionner les puces 350 en vis-à-vis des zones de report correspondantes du substrat destination 400, faces de connexion des puces 350 tournées vers la face de connexion du substrat 400, en se servant du substrat source 300 comme poignée.

Par souci de simplification des figures, les puces 350 n'ont pas été détaillées sur les figures 4A à 4C. Seules les plages de connexion électrique 342 des puces sont visibles sur ces figures.

Les puces 350, attachées au substrat source 300 par leurs LED 331 (figure 3G) via les attaches mécaniques sécables 302a (figure 3G), sont amenées en vis-à-vis de zones de réception correspondantes du substrat destination 400, faces de connexion tournées vers la face de connexion du substrat 400.

La figure 4B illustre une étape au cours de laquelle les puces 350 sont fixées sur le substrat destination 400 et connectées électriquement au substrat destination 400, par fixation et connexion des plages de connexion électrique 342 des puces sur les plages de connexion électrique 402 correspondantes du substrat 400. A titre d'exemple, les plages de connexion électrique 342 des puces sont revêtues de microtubes 344 tel que décrit en relation avec la figure 3G, et les plages de connexion électrique correspondantes 402 du substrat 400 sont en protubérance. L'ensemble comprenant le substrat source 300 et les puces 350 est alors pressé contre le substrat destination 400, faces de connexion des puces 350 tournées vers la face de connexion du substrat 400. Pour chaque puce dont les plages de connexion électrique 342 sont en vis-à-vis de plages de connexion électrique 402 du substrat 400, les microtubes 344 de la puce pénètrent dans les plages de connexion électrique correspondantes 402 du substrat 400. Les modes de réalisation décrits ne se limitent toutefois pas à ce mode de connexion particulier. A titre de variante, les puces 350 peuvent être fixées par collage direct des plages de connexion électrique 342 des puces sur les plages de connexion électrique correspondantes 402 du substrat 400, par soudure ou brasure des plages 342 sur les plages 402, ou par toute autre méthode de fixation adaptée.

La figure 4C illustre une étape au cours de laquelle le substrat source 300 est retiré, ce qui entraîne la rupture des attaches mécaniques sécables reliant au substrat source 300 les puces 350, désormais solidaires du substrat destination.

En pratique, le pas p₃₀₀ des puces sur le substrat source 300, par exemple de l'ordre de 10 à 50 µm, peut être inférieur au pas P₄₀₀ du dispositif final après report sur le substrat 400, par exemple compris entre 15 µm et 1 mm, par exemple de l'ordre de 100 à 500 µm.

Dans l'exemple décrit en relation avec les figures 4A à 4C, le pas p₄₀₀ des puces 400 sur le substrat destination 400 est un multiple du pas p₃₀₀ des puces sur le substrat source 300. A titre d'exemple, p₄₀₀=N^{∗}p₃₀₀, avec N entier compris dans la plage allant de 1 à 10. Ainsi, on prévoit de reporter seulement une partie des puces 350 du substrat 300 sur le substrat 400, au pas du substrat 400 (soit une puce sur n avec n = p₄₀₀/p₃₀₀), puis, si besoin, de décaler le substrat 300 avec les puces restantes pour reporter une autre partie des puces du substrat 300 sur le substrat 400, et ainsi de suite jusqu'à ce que toutes les puces du dispositif d'affichage aient été fixées sur le substrat destination 400.

A chaque itération, les puces 350 sont détachées sélectivement du substrat source 300. Le substrat source 300 et les puces 350 restantes sont ensuite retirés comme illustré par la figure 4C.

La prévision des attaches mécaniques sécables reliant les puces 350 au substrat source 300 permet aisément de détacher sélectivement les puces 350 du substrat source 300. En effet, lors du retrait du substrat source 300, seules les puces fixées au substrat destination 400 sont détachées du substrat source 300, par rupture de leurs attaches mécaniques sécables, les autres puces restant fixées au substrat source du fait de l'absence de liaison entre ces puces et le substrat destination. On notera que la prévision, côté substrat destination 400, de plages de connexion électrique en protubérance de la face supérieure du substrat 400, permet de faciliter la fixation sélective des puces sur le substrat destination 400, et donc le détachage sélectif des puces du substrat source 300 lors du retrait du substrat 300.

Par rapport aux procédés de transfert décrits dans la demande de brevet internationale WO2015/193435 susmentionnée, un avantage du procédé décrit en relation avec les figures 4A à 4C est que le transfert est réalisé directement du substrat source au substrat destination, sans passer par un substrat de transfert intermédiaire, ce qui facilite la mise en oeuvre du transfert.

Des modes de réalisation particuliers ont été décrits. Diverses variantes et modifications apparaîtront à l'homme de l'art. En particulier, les modes de réalisation décrits ne se limitent ni aux exemples de procédés de fabrication des attaches mécaniques sécables décrits en relation avec les figures 1A à 1G et 3A à 3G, ni aux exemples de formes des attaches mécaniques sécables décrits en relation avec les figures 1A à 1G et 3A à 3G. Plus généralement, les attaches mécaniques sécables peuvent être réalisées par tout procédé comprenant une alternance d'au moins une étape de dépôt d'une couche solide permanente, par exemple en oxyde de silicium, et d'au moins une étape de dépôt d'une couche solide sacrificielle, par exemple en silicium polycristallin, ou en un métal gravable sélectivement, par exemple en gravure humide, par rapport aux autres matériaux de la structure. Les couches solides permanentes et sacrificielles successives peuvent comprendre des ouvertures, par exemple réalisées par photolithographie et gravure, en particulier pour définir la forme des attaches mécaniques sécables et pour permettre le retrait total de la ou des couches sacrificielles une fois les puces solidarisées au substrat source et individualisées.

On notera par ailleurs que dans un dispositif de report du type décrit en relation avec la figure 1G ou 3G, du fait de la faible distance séparant chaque puce élémentaire du substrat source, il peut arriver que la face arrière de la puce (la face inférieure dans l'orientation des figures 1G et 3G) vienne se plaquer contre la face supérieure du substrat source, notamment lorsqu'une pression verticale est appliquée sur la face avant de la puce. Dans ce cas, pour éviter que la puce ne reste collée, par collage moléculaire, à la face supérieure du substrat source, on peut prévoir de conférer une certaine rugosité à la face supérieure du substrat source (la face supérieure de la couche 102 dans l'exemple de la figure 1G ou la face supérieure de la couche 306 dans l'exemple de la figure 3G), par exemple une rugosité supérieure à 5 nm.

De plus, les modes de réalisation décrits ne se limitent pas aux exemples de matériaux et de dimensions mentionnés dans la présente description.

## Revendications

1. Dispositif pour le report de puces d'un substrat source vers un substrat destination, comportant :
un substrat source (100) ayant une face inférieure et une face supérieure ; et
une pluralité de puces élémentaires (150) disposées sur la face supérieure du substrat source,
dans lequel chaque puce élémentaire (150) est suspendue au-dessus du substrat source (100) par au moins une attache mécanique sécable (120), ladite au moins une attache mécanique sécable étant située entièrement sous la puce et comprenant :
- une première portion (120a) ayant une face inférieure fixée à la face supérieure du substrat source (100) et une face supérieure séparée de la face inférieure de la puce (150) par une région libre de tout matériau solide ;
- une deuxième portion (120b) ayant une face supérieure fixée à la face inférieure de la puce (150) et une face inférieure séparée de la face supérieure du substrat source (100) par une région libre de tout matériau solide ; et
- une troisième portion (120c) s'étendant depuis un bord latéral de la première portion (120a) jusqu'à un bord latéral de la deuxième portion (120c), la troisième portion (120c) ayant une face inférieure séparée du substrat source (100) par une région libre de tout matériau solide et une face supérieure séparée de la puce (150) par une région libre de tout matériau solide.

2. Dispositif selon la revendication 1, dans lequel chaque puce élémentaire (150) comprend une ou plusieurs bornes de connexion électrique (132) à un dispositif extérieur disposées du côté de sa face opposée au substrat source (100).

3. Dispositif selon la revendication 1 ou 2, dans lequel chaque puce élémentaire (150) comprend en outre une ou plusieurs bornes de connexion électrique à un dispositif extérieur disposées du côté de sa face tournée vers le substrat source (100).

4. Dispositif selon l'une quelconque des revendications 1 à 3, dans lequel la face supérieure du substrat source (100) présente une rugosité de surface supérieure à 5 nm.

5. Dispositif selon l'une quelconque des revendications 1 à 4, dans lequel chaque puce élémentaire comprend une LED (331).

6. Dispositif selon l'une quelconque des revendications 1 à 5, dans lequel chaque puce élémentaire comprend un empilement d'une LED (331) et d'un circuit élémentaire (321) de commande de la LED, le circuit élémentaire de commande (321) étant disposé du côté de la LED (331) opposé au substrat source.

7. Dispositif selon l'une quelconque des revendications 1 à 6, dans lequel chaque puce élémentaire est un élément de conversion de longueur d'onde.

8. Procédé de fabrication d'un dispositif selon l'une quelconque des revendications 1 à 7, comportant les étapes successives suivantes :
a) former sur la face supérieure du substrat source (100) un premier empilement comprenant une alternance d'au moins une couche solide permanente (102, 106, 112) et d'au moins une couche sacrificielle (104, 108) de façon à définir les attaches mécaniques sécables (120) du dispositif ;
b) rapporter sur la face supérieure du premier empilement une couche fonctionnelle (130) ;
c) former des tranchées de singularisation (140) traversant la couche fonctionnelle (130) et délimitant les puces élémentaires (150) du dispositif ; et
d) graver ladite au moins une couche sacrificielle de l'empilement de liaison sans retirer ladite au moins une couche solide permanente.

9. Procédé de fabrication d'un dispositif selon l'une quelconque des revendications 1 à 7, comportant les étapes successives suivantes :
a) former une couche fonctionnelle (320, 330) sur une face d'un substrat de support temporaire (310) ;
b) former, sur la face de la couche fonctionnelle (320, 330) opposée au substrat de support temporaire (310), un empilement de liaison comprenant une alternance d'au moins une couche solide permanente (302, 306) et d'au moins une couche sacrificielle (304) de façon à définir les attaches mécaniques sécables (302a) du dispositif ;
c) rapporter l'ensemble comprenant le substrat de support temporaire (310), la couche fonctionnelle (320, 330) et l'empilement de liaison sur la face supérieure du substrat source (300), de façon que le substrat de support temporaire (310) soit disposé du côté de l'empilement de liaison opposé au substrat source (300), puis retirer le substrat de support temporaire (310) ;
d) former des tranchées de singularisation (370) traversant la couche fonctionnelle (320, 330) et délimitant les puces élémentaires (350) du dispositif ; et
e) graver ladite au moins une couche sacrificielle de l'empilement de liaison sans retirer ladite au moins une couche solide permanente.

10. Procédé selon la revendication 8 ou 9, dans lequel ladite au moins une couche solide permanente (102, 106, 112 ; 302, 306) est en oxyde de silicium, et dans lequel ladite au moins une couche sacrificielle (104, 108 ; 304) est en silicium polycristallin.

11. Procédé selon l'une quelconque des revendications 8 à 10, dans lequel l'étape de graver ladite au moins une couche sacrificielle de l'empilement de liaison sans retirer ladite au moins une couche solide permanente est réalisée par gravure à base de di-fluorure de xénon (XeF2).

12. Procédé de transfert de puces élémentaires (350) d'un substrat source (300) sur un substrat destination (400) au moyen d'un dispositif selon l'une quelconque des revendications 1 à 7, comprenant les étapes successives suivantes :
positionner les puces élémentaires (350) en vis-à-vis de zones de report correspondantes du substrat destination (400) en se servant du substrat source (300) comme poignée ;
fixer les puces élémentaires (350) sur le substrat destination (400) par leur face opposée au substrat source (300) ; et
éloigner le substrat source (300) du substrat destination de façon à rompre les attaches mécaniques sécables reliant au substrat source (300) les puces élémentaires (350) désormais solidaires du substrat destination.

13. Procédé selon la revendication 12, dans lequel l'étape de fixation des puces élémentaires (350) sur le substrat destination (400) comprend la connexion électrique de bornes de connexion électrique (342) préalablement formées sur la face des puces élémentaires (350) opposée au substrat source (300), à des bornes de connexion électrique correspondantes (402) du substrat destination (400).

14. Procédé selon la revendication 12 ou 13, dans lequel le pas (p₃₀₀) des puces élémentaires (350) sur le substrat source (300) est inférieur au pas (p₄₀₀) des puces élémentaires (350) sur le substrat destination.

## Patentansprüche

1. Eine Einrichtung für die Übertragung von Chips von einem Quellsubstrat auf ein Zielsubstrat, wobei die Einrichtung Folgendes aufweist:
ein Quellsubstrat (100) mit einer unteren Oberfläche und einer oberen Oberfläche; und
eine Vielzahl von Elementarchips (150), die auf der oberen Oberfläche des Quellsubstrats angeordnet sind,
wobei jeder Elementarchip (150) über dem Quellsubstrat (100) durch mindestens ein zerbrechliches mechanisches Befestigungselement (120) aufgehängt ist, wobei das mindestens eine zerbrechliche mechanische Befestigungselement vollständig unter dem Chip angeordnet ist und Folgendes aufweist:
- einen ersten Abschnitt (120a) mit einer unteren Oberfläche, die an der oberen Oberfläche des Quellsubstrats (100) befestigt ist, und einer oberen Oberfläche, die von der unteren Oberfläche des Chips (150) durch einen Bereich getrennt ist, der frei von jeglichem festen Material ist;
- einen zweiten Abschnitt (120b) mit einer oberen Oberfläche, die an der unteren Oberfläche des Chips (150) befestigt ist, und einer unteren Oberfläche, die von der oberen Oberfläche des Quellsubstrats (100) durch einen Bereich getrennt ist, der frei von jeglichem festen Material ist; und
- einen dritten Abschnitt (120c), der sich von einer Seitenkante des ersten Abschnitts (120a) zu einer Seitenkante des zweiten Abschnitts (120c) erstreckt, wobei der dritte Abschnitt (120c) eine untere Oberfläche, die von dem Quellsubstrat (100) durch einen Bereich getrennt ist, der frei von jeglichem festen Material ist, und eine obere Oberfläche aufweist, die von dem Chip (150) durch einen Bereich getrennt ist, der frei von jeglichem festen Material ist.

2. Einrichtung nach Anspruch 1, wobei jeder Elementarchip (150) einen oder eine Vielzahl von Anschlüssen (132) für eine elektrische Verbindung mit einer externen Einrichtung aufweist, die auf der dem Quellsubstrat (100) gegenüberliegenden Seite seiner Oberfläche angeordnet ist.

3. Einrichtung nach Anspruch 1 oder 2, wobei jeder Elementarchip (150) ferner einen oder mehrere Anschlüsse für eine elektrische Verbindung mit einer externen Einrichtung aufweist, die auf der Seite seiner Oberfläche angeordnet ist, die dem Quellsubstrat (100) gegenüberliegt.

4. Einrichtung nach einem der Ansprüche 1 bis 3, wobei die obere Oberfläche des Quellsubstrats (100) eine Oberflächenrauigkeit von mehr als 5 nm aufweist.

5. Einrichtung nach einem der Ansprüche 1 bis 4, wobei jeder Elementarchip eine LED (331) aufweist.

6. Einrichtung nach einem der Ansprüche 1 bis 5, wobei jeder Elementarchip einen Stapel aus einer LED (331) und einer elementaren LED-Steuerschaltung (321) aufweist, wobei die elementare Steuerschaltung (321) auf der dem Quellsubstrat gegenüberliegenden Seite der LED (331) angeordnet ist.

7. Einrichtung nach einem der Ansprüche 1 bis 6, wobei jeder Elementarchip ein Wellenlängenumwandlungselement ist.

8. Ein Verfahren zur Herstellung der Einrichtung nach einem der Ansprüche 1 bis 7, wobei das Verfahren die aufeinanderfolgenden Schritte aufweist:
a) Bilden eines ersten Stapels auf der oberen Oberfläche des Quellsubstrats (100), der abwechselnd mindestens eine feste Dauerschicht (102, 106, 112) und mindestens eine Opferschicht (104, 108) aufweist, um die zerbrechlichen mechanischen Befestigungen (120) der Einrichtung zu definieren;
b) Anordnen einer Funktionsschicht (130) auf der oberen Oberfläche des ersten Stapels;
c) Bilden von Vereinzelungsgräben (140), die die Funktionsschicht (130) durchqueren und die Elementarchips (150) der Einrichtung begrenzen; und
d) Ätzen der mindestens einen Opferschicht des Verbindungsstapels, ohne die mindestens eine permanente feste Schicht zu entfernen.

9. Ein Verfahren zur Herstellung der Einrichtung nach einem der Ansprüche 1 bis 7, wobei das Verfahren die aufeinanderfolgenden Schritte aufweist:
a) Bilden einer Funktionsschicht (320, 330) auf einer Oberfläche eines temporären Trägersubstrats (310);
b) Bilden eines Verbindungsstapels auf der Oberfläche der Funktionsschicht (320, 330) gegenüber dem temporären Trägersubstrat (310), wobei der Verbindungsstapel abwechselnd mindestens eine permanente feste Schicht (302, 306) und mindestens eine Opferschicht (304) aufweist, um die zerbrechlichen mechanischen Befestigungen (302a) der Einrichtung zu definieren;
c) Platzieren der Anordnung, die das temporäre Trägersubstrat (310), die Funktionsschicht (320, 330) und den Verbindungsstapel aufweist, auf der oberen Oberfläche des Quellsubstrats (300), so dass das temporäre Trägersubstrat (310) auf der dem Quellsubstrat (300) gegenüberliegenden Seite des Verbindungsstapels angeordnet ist, und dann Entfernen des temporären Trägersubstrats (310);
d) Bilden von Vereinzelungsgräben (370), die die Funktionsschicht (320, 330) kreuzen und die Elementarchips (350) der Einrichtung abgrenzen; und
e) Ätzen der mindestens einen Opferschicht des Verbindungsstapels, ohne die mindestens eine permanente feste Schicht zu entfernen.

10. Verfahren nach Anspruch 8 oder 9, wobei die mindestens eine permanente feste Schicht (102, 106, 112; 302, 306) aus Siliziumoxid hergestellt ist und wobei die mindestens eine Opferschicht (104, 108; 304) aus Polysilizium hergestellt ist.

11. Verfahren nach einem der Ansprüche 8 bis 10, wobei der Schritt des Ätzens der mindestens einen Opferschicht des Verbindungsstapels, ohne die mindestens eine permanente feste Schicht zu entfernen, durch Ätzen auf der Basis von Xenondifluorid (XeF2) durchgeführt wird.

12. Ein Verfahren zum Übertragen von Elementarchips (350) von einem Quellsubstrat (300) auf ein Zielsubstrat (400) mit Hilfe einer Einrichtung nach einem der Ansprüche 1 bis 7, wobei das Verfahren die aufeinanderfolgenden Schritte aufweist:
Positionieren der Elementarchips (350) gegenüber korrespondierenden Transferbereichen des Zielsubstrats (400), wobei das Quellsubstrat (300) als Griff verwendet wird;
Befestigen der Elementarchips (350) an dem Zielsubstrat (400) durch ihre dem Quellsubstrat (300) gegenüberliegende Oberfläche;
Entfernen des Quellsubstrats (300) von dem Zielsubstrat, um die zerbrechlichen mechanischen Befestigungen zu brechen, die die Elementarchips (350), die nun fest mit dem Zielsubstrat verbunden sind, mit dem Quellsubstrat (300) verbinden.

13. Verfahren nach Anspruch 12, wobei der Schritt des Befestigens der Elementarchips (350) an dem Zielsubstrat (400) die elektrische Verbindung von elektrischen Verbindungsanschlüssen (342), die zuvor auf der dem Quellsubstrat (300) gegenüberliegenden Oberfläche der Elementarchips (350) ausgebildet wurden, mit entsprechenden elektrischen Verbindungsanschlüssen (402) des Zielsubstrats (400) aufweist.

14. Verfahren nach Anspruch 12 oder 13, wobei der Abstand (p300) der Elementarchips (350) auf dem Quellsubstrat (300) kleiner ist als der Abstand (p400) der Elementarchips (350) auf dem Zielsubstrat.

## Claims

1. A device for the transfer of chips from a source substrate onto a destination substrate, comprising:
a source substrate (100) having a lower surface and an upper surface; and
a plurality of elementary chips (150) arranged on the upper surface of the source substrate,
wherein each elementary chip (150) is suspended above the source substrate (100) by at least one breakable mechanical fastener (120), said at least one breakable mechanical fastener being entirely located under the chip and comprising:
- a first portion (120a) having a lower surface fastened to the upper surface of the source substrate (100) and an upper surface separated from the lower surface of the chip (150) by a region free of any solid material;
- a second portion (120b) having an upper surface fastened to the lower surface of the chip (150) and a lower surface separated from the upper surface of the source substrate (100) by a region free of any solid material; and
- a third portion (120c) extending from a lateral edge of the first portion (120a) to a lateral edge of the second portion (120c), the third portion (120c) having a lower surface separated from the source substrate (100) by a region free of any solid material and an upper surface separated from the chip (150) by a region free of any solid material.

2. The device of claim 1, wherein each elementary chip (150) comprises one or a plurality of terminals (132) of electric connection to an external device arranged on the side of its surface opposite to the source substrate (100).

3. The device of claim 1 or 2, wherein each elementary chip (150) further comprises one or a plurality of terminals of electric connection to an external device arranged on the side of its surface facing the source substrate (100).

4. The device of any of claims 1 to 3, wherein the upper surface of the source substrate (100) has a surface roughness greater than 5 nm.

5. The device of any of claims 1 to 4, wherein each elementary chip comprises a LED (331).

6. The device of any of claims 1 to 5, wherein each elementary chip comprises a stack of a LED (331) and of an elementary LED control circuit (321), the elementary control circuit (321) being arranged on the side of the LED (331) opposite to the source substrate.

7. The device of any of claims 1 to 6, wherein each elementary chip is a wavelength conversion element.

8. A method of manufacturing the device of any of claims 1 to 7, comprising the successive steps of:
a) forming on the upper surface of the source substrate (100) a first stack comprising an alternation of at least one permanent solid layer (102, 106, 112) and of at least one sacrificial layer (104, 108) to define the breakable mechanical fasteners (120) of the device;
b) placing on the upper surface of the first stack a functional layer (130);
c) forming singulation trenches (140) crossing the functional layer (130) and delimiting the elementary chips (150) of the device; and
d) etching said at least one sacrificial layer of the connection stack without removing said at least one permanent solid layer.

9. A method of manufacturing the device of any of claims 1 to 7, comprising the successive steps of:
a) forming a functional layer (320, 330) on a surface of a temporary support substrate (310);
b) forming, on the surface of the functional layer (320, 330) opposite to the temporary support substrate (310), a connection stack comprising an alternation of at least one permanent solid layer (302, 306) and of at least one sacrificial layer (304) to define the breakable mechanical fasteners (302a) of the device;
c) placing the assembly comprising the temporary support substrate (310), the functional layer (320, 330), and the connection stack on the upper surface of source substrate (300), so that the temporary support substrate (310) is arranged on the side of the connection stack opposite to the source substrate (300), and then removing the temporary support substrate (310);
d) forming singulation trenches (370) crossing the functional layer (320, 330) and delimiting the elementary chips (350) of the device; and
e) etching said at least one sacrificial layer of the connection stack without removing said at least one permanent solid layer.

10. The method of claim 8 or 9, wherein said at least one permanent solid layer (102, 106, 112; 302, 306) is made of silicon oxide and wherein said at least one sacrificial layer (104, 108; 304) is made of polysilicon.

11. The method of any of claims 8 to 10, wherein the step of etching said at least one sacrificial layer of the connection stack without removing said at least one permanent solid layer is carried out by etching based on xenon difluoride (XeF2).

12. A method of transferring elementary chips (350) from a source substrate (300) onto a destination substrate (400) by means of the device of any of claims 1 to 7, comprising the successive steps of:
positioning the elementary chips (350) opposite corresponding transfer areas of the destination substrate (400), using the source substrate (300) as a handle;
fastening the elementary chips (350) to the destination substrate (400) by their surface opposite to the source substrate (300) ;
removing the source substrate (300) from the destination substrate to break the breakable mechanical fasteners connecting to the source substrate (300) the elementary chips (350) which are now solid with the destination substrate.

13. The method of claim 12, wherein the step of fastening the elementary chips (350) to the destination substrate (400) comprises the electric connection of electric connection terminals (342) previously formed on the surface of the elementary chips (350) opposite to the source substrate (300) to corresponding electric connection terminals (402) of the destination substrate (400).

14. The method of claim 12 or 13, wherein the pitch (p₃₀₀) of the elementary chips (350) on the source substrate (300) is smaller than the pitch (p₄₀₀) of the elementary chips (350) on the destination substrate.
